# EUROPEAN PATENT APPLICATION

(11) **EP 2 081 295 A1**
(43) Date of publication of application: **22.07.2009**
(21) Application number: 08100683.5
(22) Date of filing: 21.01.2008
(51) Int. Cl.: H03K 7/08, H03K 5/13

(54) **A device and a method for generating a PWM signal and a system using a PWM signal**

(71) Applicant: ROBERT BOSCH GMBH, 70442 Stuttgart (DE)
(72) Inventor: Kassner, Uwe, 71696 Moeglingen (DE)

(57) **Abstract**

The invention relates to a device, method and a system used for generating a pulse width modulated signal having a lower resolution than the input signal and improving the resolution in the recovered analog signal to the same levels as that of input. The improvement in the resolution of recovered analog signal is achieved by generating a set of PWM frames corresponding to one input. The recovery unit reconstructs the analog signal from PWM frames achieving a better resolution.

## Description

### State of the Art

The invention relates to a method and a device for generating PWM frames corresponding to a digital input.

There are different types of devices and circuits in use to generate PWM signal, known in the state of the art. Also most of the microcontrollers have integrated PWM generator on the chip. The patent US6133653 discloses such a PWM generator.

### Advantages of the invention

The device, method and system according to the independent patent claims have the below mentioned advantages:

The PWM generator receives a higher resolution digital input, generates PWM frames of a lower resolution. The recovery unit reconstructs the analog signal from the PWM frames, the analog signal having similar resolution as that of input. Thus a lower resolution PWM generator is used to transmit a higher resolution digital input.

The improvement in resolution in the recovered signal is achieved by a simple method of generating multiple frames of PWM signal for each digital input.

The complete system, which receives digital input and generates an analog output of the similar resolution as digital input, but using a lower resolution PWM generator, is simple and comprises of the PWM generator and a recovery unit which will recover analog signal from PWM signal using a simple recovery circuit like a low pass filter.

Further improvements and/or advantages are realised by the features of the dependent patent claims.

The number of PWM frames to be generated for each input is computed using a simple logic. The number of PWM frames is given as "2 to the power n", where n is the difference between the resolution of PWM frames and resolution of digital input. For example, if the input has 10 bits and the PWM has 8 bit resolution, the number of PWM frames to be generated is 4.

### Brief descriptions of the drawings

- Figure 1: shows the schematic view of a PWM generator and a recovery unit
- Figure 2: shows PWM signal for different input values and the corresponding recovered analog signal
- Figure 3: shows PWM frames for different intermediate inputs and the recovered analog signal
- Figure 4: shows the PWM generator integrated into a microcontroller
- Figure 5: shows the system comprising of PWM generator, a recovery unit, used for an application for active noise cancellation

### Description of the embodiments

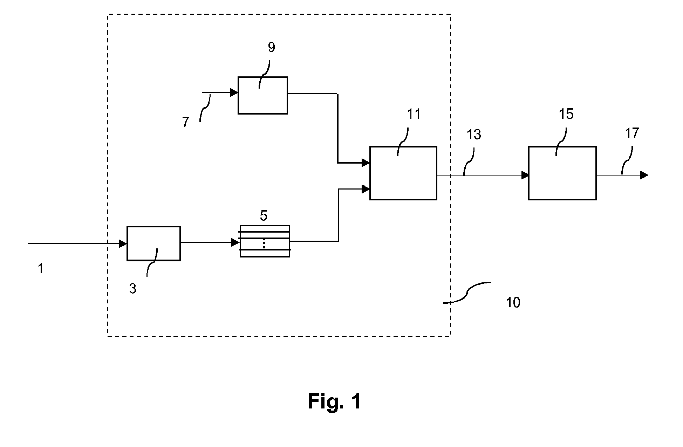

The figure 1 shows schematic view of a PWM generator and a recovery unit.

PWM generators along with recovery units are used to convert a digital data into analog signal. The PWM generators are cost effective compared to digital to analog converters. Normally the PWM generators use simple circuits like counters and comparators. This advantage of PWM generators over digital to analog converters makes them a necessary choice for integrating into most of the microcontrollers.

The PWM generator in the invention receives an input which is a number with a certain resolution. The resolution of the input is defined as the number of bits used to represent the input. For example, 8 bit input, 10 bit input etc. The 8 bit input can have values from 0 to 255 where as the 10 bit input can have values from 0 to 1023.

Also the PWM signal has a resolution which is defined as the number of bits used to represent the possible duty cycles.

The 8 bit PWM signal will have 256 possible duty cycles, a 10 bit PWM signal will have 1024 possible duty cycles.

Fig 1 shows a PWM generator 10 and a recovery unit 15. The PWM generator 10 has a receiving unit 3, plurality of compare registers 5, a counter 9 and a comparator 11. The receiving unit 3 receives an input (Ex. 10 bit number) over the input line 1, converts it into plurality of intermediate inputs and stores them in the plurality of compare registers 5. The counter 9 receives a clock signal over the line 7. The output from the counter 9 is given to the comparator 11. The comparator 11 also receives the intermediate inputs form the compare registers 5.

The PWM generator 10 in Fig 1 generates a plurality of PWM frames in dependence of the input. The resolution of the input is higher than the resolution of each PWM frame. For each input, a plurality of PWM frames are generated.

In the explanation PWM frame always refers to a single PWM pulse and PWM signal refers to a set of PWM frames corresponding to one input value.

The recovery unit 15 recovers the analog signal by averaging out the PWM frames.

To start with the generation of the PWM signal based on input, the receiving unit 3 receives the input from an external source over the connection 1. The receiving unit converts the input into a plurality of intermediate inputs. The number of intermediate inputs depends on the resolution of the input and the resolution of the PWM generator. The intermediate inputs are stored in the compare registers 5. The PWM output line 13 is made high and the counter 9 is set to zero.

The counter 9 starts incrementing for every clock. With every increment of the counter, the comparator 11 compares the counter output with the first compare register 5. When the counter 9 equals the first compare register 5, the PWM output line 13 is made low. The counter 9 continues incrementing till it reaches a maximum value of the counter. When the maximum value is reached, the counter 9 is reset to zero and the first cycle of generating a PWM frame is completed.

For the next PWM frame, the PWM output line 13 is made high, the next compare register is given to comparator and the counter is reset to zero. The next PWM frame is generated based on the counter and the contents of compare register. This process is performed until all the comparators are used. After this process has been completed, the PWM generator 10 is ready to accept a new input to generate the next set of PWM frames.

The recovery unit 15 uses this set of PWM frames of lower resolution to recover analog signal of higher resolution.

The above sequence is explained with an example below for better understanding.

Suppose the PWM generator is an 8 bit device, which means that the counter and the compare registers work with 8 bit data. Hence the counter can count from 0 to 255 and also the comparator registers can hold values from 0 to 255 which means that the registers can store 8 bit data.

The smallest duty cycle of the PWM frame will be 1/255.

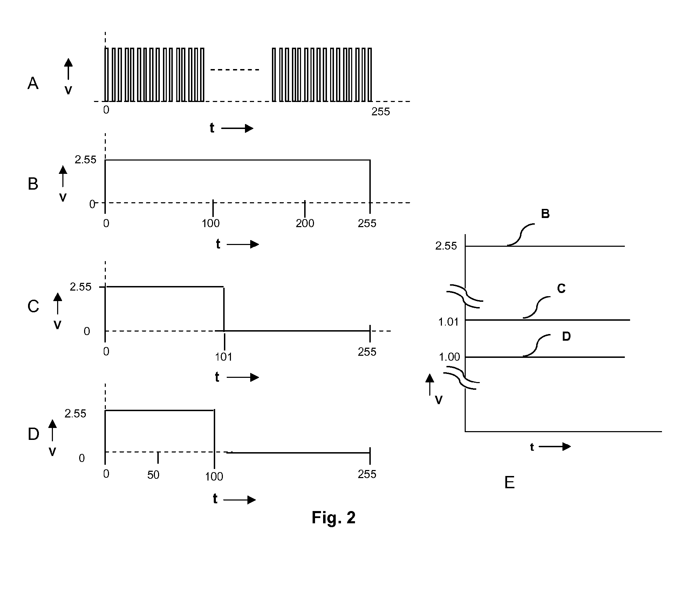

Fig 2 shows the output of PWM generator and the corresponding approximated analog signals recovered by the recovery unit. The recovered signals are referred as approximated signals because, if the recovery unit integrates the PWM frames over a longer period of time, then the signals appear approximately as shown in Fig 2E B, C and D.

The actual signals may not be so smooth in levels and there may be ripples of the PWM frequency. For easy understanding, the recovered signals are approximated to smooth levels and shown in Fig 2E.

The X axis in the Fig 2 represents time period and the Y axis represents the amplitude in terms of volts.

The Fig 2A shows the clock signals applied to the counter. Shown is the time scale of 255 clock pulses between voltage levels of high and low.

The Fig 2B, 2C and 2D show PWM signals for different inputs. The PWM signal has two levels, low level and high level. For simplicity, it is shown that low level is represented by 0 volts and high level by 2.55 volts. When the input to PWM generator is 255, the duty cycle of the PWM signal is 100% as shown in Fig 2B. The recovered analog signal is shown in Fig 2E B. The signal has amplitude of 2.55 volts which corresponds to input value of 255. When the input is 100, the duty cycle of the PWM signal is 100/255 as shown in Fig 2C. The recovered analog signal is shown in Fig 2E C. The signal has amplitude of 1.00 volts which corresponds to input value of 100. Similarly for an input of 101 the recovered signal has amplitude of 1.01 volts as shown in Fig 2 E D
We observe that there is no step between 1.00 and 1.01 because there is no input value possible between 100 and 101. The invention tries to overcome this limitation with a simple logic.

Suppose the input has 10 bit resolution and the PWM generator has 8 bit resolution. The input can have any value between 0 and 1023. We take input as 400 for example.

Referring to Fig 1, the receiving unit 3 receives the input 400 from the external source over the line 1. The input 400 needs to be converted into intermediate inputs of 8 bits so that these intermediate inputs can be stored in the compare registers 5.

The number of intermediate inputs needed is computed as "2 to the power n", where n is the difference between resolution of input and resolution of PWM generator.

In the above case number of intermediate inputs needed are:
2² (because the difference in resolution is 2 i.e. 10-8) = 4.

The input is divided into 4 intermediate inputs. And if the remainder is one, one of the intermediate inputs is incremented. If the remainder is two, then two of the intermediate inputs are incremented and if the remainder is three, then three of the intermediate inputs are incremented.

So for an input of 400, the intermediate inputs will be 100, 100, 100, and 100 as there is no remainder when input is divided by 4.

For an input of 401, the intermediate inputs will be 100, 100, 100, and 101.

For an input of 402, the intermediate inputs will be 100, 100, 101, and 101. (or 100, 101, 100, 101) or (101, 101, 100, 100).

For an input of 403, the intermediate inputs will be 101, 101, 101, and 100. Or 100, 101, 101, 101

So, for the example with input as 400, the four intermediate values are computed as 100, 100, 100, 100 and stored in the compares registers 5. The PWM output line 13 is made high and the counter 9 starts counting. The comparator 11 uses first intermediate input 100 from compare register 7 for comparison. When counter 9 reaches 100, the PWM output on 13 is made low. The counter 9 continues to count till 255 and then resets to zero. The PWM output on 13 is made high. The cycle is repeated with all other intermediate values form compare register 5.

In the above example it is noticed that for one input of 400, there are 4 PWM frames generated. And until the complete set of PWM frames is generated for one input, the PWM generator can not accept a new input. This will put a limitation on the input frequency.

But for typical applications the PWM frequency will be much higher than the frequency of the input signal. For example, a typical active noise cancellation application for an automobile will be having input frequency of approximately 2 kHz and the PWM frequency can be in the range of 40 kHz. This implies that the PWM generator will generate 20 PWM frames before a change in the input occurs. But these 20 PWM frames will be identical as the input remains same during this period.

The invention uses the frequency difference between the input and the PWM frames as an advantage and proposes a simple method to transmit the high resolution input using a low resolution PWM generator. This is achieved by dividing the input into intermediate inputs and generating a PWM frame for each intermediate input. The recovery unit will generate an analog signal which is averaged value of the PWM frames. The recovered analog signal will have similar resolution as that of the input.

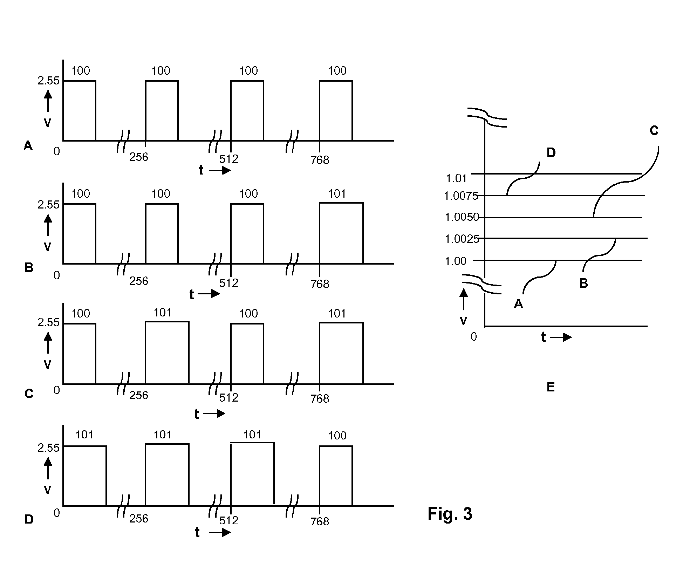

Fig 3 shows PWM frames for different inputs. Shown in Fig 3 A, B, C and D are the intermediate inputs corresponding to the input. The X axis shows the time scale and the Y axis shows the amplitude in terms of volts.

For the input 400 and the intermediate inputs 100, 100, 100, and 100, the PWM frames are as shown in Fig 3A. When the recovery unit recovers analog signal from the PWM frames, the analog signal will be average value of the four PWM frames. So we get an analog signal with amplitude of 1.00 V (corresponding to average value of input 100) as shown in Fig 3E A.

If the input is 401, the intermediate inputs will be 100, 100, 100 and 101 and corresponding to each intermediate input, a PWM frame is generated as shown in Fig 3B. When the recovery unit recovers analog signal from the PWM frames, the analog signal will be average value. So we get an analog signal with amplitude of 1.0025 V as shown Fig 3E B.

Similarly for the input 402, the intermediate inputs are 100, 101, 100, 101 and the PWM frames are generated as shown in Fig 3C. When the recovery unit recovers analog signal from the PWM frames, the analog signal will be average value. So we get an analog signal with amplitude of 1.0050 V as shown in Fig 3E C.

For input of 403, the analog signal will be with amplitude 1.0075 as shown in Fig 3E D.

For input of 404, the analog signal will be with amplitude 1.01 volts, as all the intermediate values will be 101.

With the above examples it is observed that, for one input of higher resolution, a set of PWM frames with lower resolution are generated. The recovery unit integrates or averages the PWM frames to recover the analog signal. Because of the averaging, the recovered analog signal will have a better resolution.

But this is achieved by a trade off. The trade off is in limitation in the frequency of the input. Because the PWM generator has to generate multiple frames for a single input, the input can not change before the PWM generator completes generation of complete set of PWM frames. There is a relationship between the input frequency and PWM frequency based on the difference in the resolution.

For example, if the input has 10 bit resolution and PWM has 8 bit resolution, as explained earlier the number of PWM frames to be generated is 4. In this case, the input can have maximum frequency of 1/4^{th} of the PWM frequency.

If the input has 11 bit resolution and PWM has 8 bit resolution, , the number of PWM frames to be generated is 8. (i.e. 2 to the power 3). In this case, the input can have maximum frequency of 1/8^{th} of the PWM frequency.

But as explained earlier, for most of the applications where PWM is involved, the PWM frequency will be much higher than the input frequency. So PWM can generate multiple frames for one input value, before the next value of the input arrives.

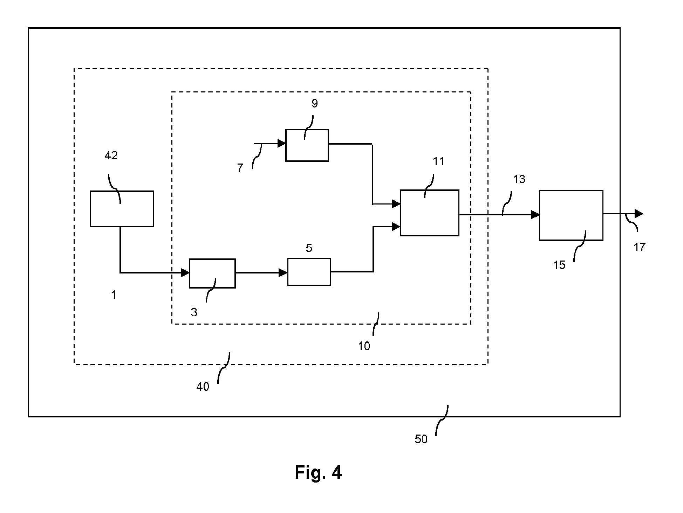

Figure 4 shows another embodiment of the invention. The PWM generator 10 is integrated into a microcontroller 40. This embodiment has all the components shown in Fig 1, in addition there is a control function 42 which is connected to the receiving unit 3 over the line 1. The control function 42 is responsible to provide the input to the receiving unit 3 for which a PWM signal needs to be generated. The control function 42 is a software module and can directly write the input value into the receiving unit 3. The functionality of the PWM generator 10 is same as explained with respect to the Fig 1. One of the microcontroller pin is used to output the PWM signal, as shown with 13. The PWM output 13 is connected to the recovery unit 15, which will recover the analog signal from the PWM frames.

In the above embodiments, the PWM generator was shown as a hardware component. But alternatively, the PWM generator can be implemented completely using only software. The software will be running in the microcontroller and comprises a counter module and a comparator module. The PWM signal is output on a microcontroller pin using a software function.

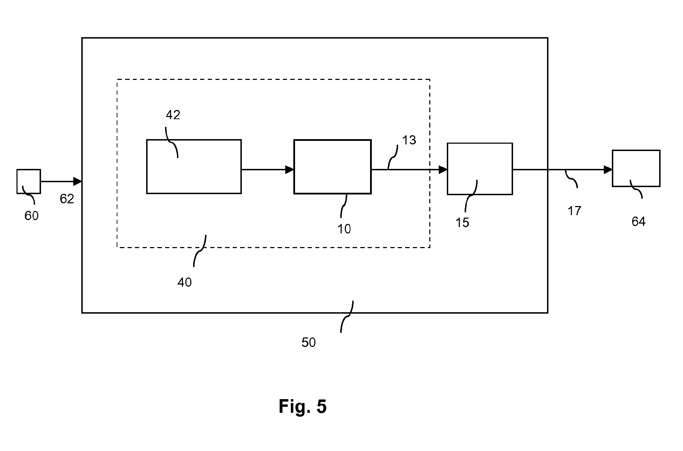

Fig 5 shows the system 50 being used for an application of an active noise cancellation for automobiles. The system comprises a PWM generator 10 which is integrated into a microcontroller 40, a control function 42, a recovery unit 15, a sound sensor 60 and a sound converter 64.

The active noise cancellation is a technique where an anti noise signal is generated which has equal amplitude but opposite phase compared to the noise signal. When the noise signal and the anti-noise signal are acoustically combined, the two signals effectively cancel one another, significantly reducing the noise.

The sound sensor 60 and sound converter 64 are placed in the close proximity of the noise is to be reduced.

The system 50 receives the noise signal from the sound sensor 60 through the line 62. The microcontroller 40 converts the noise signal which is an analog signal to a digital input using internal analog to digital converters. The control function 42 processes the input and transforms it in such a way that the analog signal recovered by recovery unit 15 will be in opposite phase compared to the input signal from sound sensor 62. The control function sends the transformed input to the PWM generator 10. The PWM generator 10 generates the PWM frames corresponding to the input. The recovery unit 15 receives the PWM frames over the line 13. The recovery unit recovers the analog signal which is referred as anti noise signal, from the PWM frames. The anti noise signal is given to a sound converter 64 through a line 17. The sound converter converts the analog signal into sound. As this sound is in opposite phase to the noise, both cancel each other and the noise will be reduced.

Here the typical frequencies of the noise cancelled by anti noise in automobiles are less than 400 Hz, therefore the sampling frequency of control function 42 is around 2 kHz. The typical frequency of PWM signal will be 40 kHz. Because there is a large difference in input frequency and the PWM frequency, the invention can be effectively used to reduce the noise with a better accuracy using a lower resolution PWM generator and in effect a lower word length microcontroller, the word length being the width of the microcontroller registers. As the word length of the microcontrollers determines the cost of the microcontrollers, using a lower word length microcontroller reduces the cost of the system to a great extent without sacrificing the resolution of the output signal.

## Claims

1. A device for generating a pulse width modulated signal, being capable of receiving a digital input of a first resolution, using the digital input to generate a plurality of PWM frames of a second resolution, the second resolution being less than the first resolution.

2. A device according to claim 1 **characterised in that** the first resolution is the number of bits used to represent the digital input.

3. A device according to claim 1 **characterised in that** the second resolution is the number of bits used to represent PWM frame.

4. A device according to claim 1, **characterised by** a counter, a comparator and plurality of compare registers.

5. A device according to claim 1 and 4, **characterised by** alternative implementation using software.

6. A device according to claim 1 **characterised in that** the number of PWM frames for a given digital input is 2 to the power n, where n is the difference between first resolution and second resolution.

7. A method to generate a pulse width modulated signal of multiple PWM frames, **characterised by** the steps of
a. receiving a digital input of first resolution
b. generating a pulse width modulated frames of second resolution
c. the second resolution is less than the first resolution

8. A system comprising the device claimed in claim 1 and a recovery unit that converts back the PWM frames into an analog signal

9. The system according to claim 8 being capable of use in active noise cancellation application

10. The system according to claim 8 further comprising of a sound sensor and a sound converter

11. The system according to claim 9 receives the sound input from the sound sensor, generates an anti sound signal which has equal amplitude and opposite phase compared to the sound signal.

## Amended claims

### Amended claims in accordance with Rule 137(2) EPC.

**1.** A device (10) for generating a pulse width modulated signal, being capable of receiving a digital input of a first resolution, using the digital input to generate a plurality of PWM frames of a second resolution, the second resolution being less than the first resolution.

**2.** A device (10) according to claim 1 **characterised in that** the first resolution is the number of bits used to represent the digital input.

**3.** A device (10) according to claim 1 **characterised in that** the second resolution is the number of bits used to represent PWM frame.

**4.** A device (10) according to claim 1, **characterised by** a counter 9, a comparator 11 and plurality of compare registers 5.

**5.** A device (10) according to claim 1 and 4, where in the counter 9, the comparator 11 and the plurality of compare registers 5 are implemented as software functions.

**6.** A device (10) according to claim 1 **characterised in that** the number of PWM frames for a given digital input is 2 to the power n, where n is the difference between first resolution and second resolution.

**7.** A method to generate a pulse width modulated signal of multiple PWM frames, **characterised by** the steps of
a. receiving a digital input of first resolution
b. generating a pulse width modulated frames of second resolution
c. the second resolution is less than the first resolution

**8.** A system (50) comprising the device (10) for generating a pulse width modulated signal and a recovery unit (15) that converts back the PWM frames into an analogue signal, the resolution of the recovered analogue signal from the plurality of PWM frames being higher than the resolution corresponding to a single PWM frame.

**9.** The system (50) according to claim 8 being capable of use in active noise cancellation application

**10.** The system (50) according to claim 8 further comprising of a sound sensor and a sound converter

**11.** The system (50) according to claim 9 receives the sound input from the sound sensor, generates an anti sound signal which has equal amplitude and opposite phase compared to the sound signal.
